# FASCICULE DE BREVET EUROPEEN

(11) **EP 2 009 682 B1**
(45) Date de publication et mention de la délivrance du brevet: **06.04.2011**
(21) Numéro de dépôt: 08158608.3
(22) Date de dépôt: 19.06.2008
(51) Int. Cl.: H01L 21/336, H01L 29/786

(54) **Transistor à effet de champ de type finfet isolé du substrat**
Vom Substrat isolierter Finfet-Feldeffekttransistor
FinFET field-effect transistor isolated from the substrate

(30) Priorité: 26.06.2007 FR 0704568
(43) Date de publication de la demande: 31.12.2008
(73) Titulaire: STMicroelectronics (Crolles 2) SAS, 38920 Crolles (FR); IMEC, 3001 Leuven (BE)
(72) Inventeur: Lenoble, Damien, c/o STMicroelectronics (Crolles 2), 38920, Crolles (FR)
(74) Mandataire: Boire, Philippe Maxime Charles

(56) Documents cités:
- JP-A- 2006 237 376
- US-A1- 2002 011 612
- US-A1- 2005 156 202
- US-A1- 2007 102 763

## Description

La présente invention concerne un procédé de réalisation d'un transistor à effet de champ (FET) de type finFET, ainsi qu'un transistor du type obtenu par un tel procédé.

De nombreux circuits électroniques intégrés sont réalisés à titre expérimental, qui incorporent un ou plusieurs transistors à effet de champ de type finFET. Un tel transistor comprend un canal qui est orienté pour conduire un courant électrique parallèlement à la surface d'un substrat du circuit, et qui possède une section allongée perpendiculairement à cette surface du substrat. Une telle structure de transistor à effet de champ est adaptée pour former une grille qui est disposée de part est d'autre de grands côtés du canal, pour permettre un bon contrôle de l'état de conduction du transistor. Elle est aussi adaptée pour fabriquer un transistor à canaux multiples, dans lequel des canaux voisins sont séparés par une portion intermédiaire de grille.

Un transistor finFET est élaboré à partir d'au moins une portion étroite («fin» en anglais) de matériau semiconducteur qui est destinée à former le canal du transistor, et éventuellement aussi les zones de source et de drain de celui-ci. Cette portion étroite est définie par un masque qui est formé sur le substrat de silicium monocristallin à l'emplacement de celle-ci. Le matériau du substrat est alors gravé de façon directionnelle en dehors du masque, sur une hauteur déterminée qui est plus grande que la largeur du masque, de sorte que la portion étroite reste sous le masque, en étant constituée du matériau initial du substrat.

Mais la portion étroite de matériau semiconducteur qui est ainsi obtenue, et qui comprend le canal du transistor final, n'est pas isolée électriquement par rapport à la portion active du substrat du circuit, elle-même aussi en matériau semiconducteur cristallin. Il en résulte trois types de courants de fuite. Un premier courant de fuite peut circuler entre les zones de source et de drain du transistor finFET, via la portion active du substrat qui est située en dessous du canal. Ce premier courant de fuite, interne à chaque transistor, n'est pas contrôlé par la grille de celui-ci. Par ailleurs, le canal du transistor finFET est aussi en contact électrique avec les canaux d'autres transistors du même type via le substrat, ce qui produit des seconds courants de fuite qui circule entre des transistors différents, i.e. des courants de fuite inter-transistors. Enfin, un troisième courant de fuite peut aussi apparaître entre le canal de chaque transistor finFET et une partie inférieure du substrat lorsque celle-ci est connectée à une borne de potentiel électrique de référence.

Pour éviter ces courants de fuite, il est connu de réaliser le transistor finFET sur un substrat de circuit électronique intégré de type SOI, pour «Silicon On lsolator». Un tel substrat comporte, sur une partie inférieure de celui-ci, une couche intermédiaire de matériau électriquement isolant qui est surmontée d'une couche cristalline de silicium. Le document US 6,645,797 divulgue un tel procédé de réalisation d'un transistor finFET à partir d'un substrat SOI. Le transistor qui est obtenu est isolé électriquement par rapport à la partie inférieure du substrat par la couche intermédiaire de matériau isolant. Mais l'utilisation d'un substrat SOI augmente le prix de revient du circuit électronique intégré.

Il est aussi connu de réaliser une jonction électrique à proximité de la surface de contact entre la portion active du substrat et la portion étroite du canal. Une telle jonction électrique, lorsqu'elle est polarisée en inverse, isole électriquement le canal du transistor par rapport à la portion active du substrat.

Selon une première méthode qui est couramment utilisée pour réaliser une telle jonction électrique, la portion étroite est d'abord obtenue et dopée électriquement selon un premier type de dopage. Des particules dopantes d'un second type opposé au premier type de dopage sont alors implantées dans une partie inférieure de la portion étroite, en utilisant un faisceau d'implantation oblique qui est dirigé en biais vers la base de la portion étroite, à partir de chaque côté de celle-ci. L'implantation des particules dopantes dans les parties médiane et supérieure de la portion étroite doit être évitée, pour conserver l'efficacité électrique du premier dopage dans ces parties qui sont destinées à former le canal du transistor. Mais, malgré des précautions opératoires, des particules dopantes du second type de dopage sont aussi implantées involontairement dans le canal. Elles causent alors une réduction de la mobilité des porteurs électriques du canal, ainsi que des variations involontaires de la concentration effective de ces porteurs. Les caractéristiques de conduction électrique de transistors finFET qui sont réalisés de cette façon avec des paramètres opératoires identiques varient alors de façon incontrôlée, conduisant à une faible reproductibilité des circuits électroniques obtenus.

Selon une seconde méthode, la portion étroite est encore obtenue et dopée électriquement dans un premier temps, en étant recouverte d'un masque. Des particules dopantes d'un type opposé à celles du dopage de la portion étroite sont ensuite implantées dans le substrat en dehors de la zone de la surface du substrat qui est occupée par la portion étroite et occultée par le masque. Les particules dopantes du substrat sont implantées au moyen d'un faisceau qui est dirigé perpendiculairement à la surface du substrat, pour éviter que certaines de ces particules ne pénètrent dans la portion étroite par les côtés latéraux de celle-ci, qui sont perpendiculaires à la surface du substrat. Une jonction électrique apparaît alors dans la partie active du substrat en dessous de la portion étroite, du fait d'une diffusion latérale des particules dopantes parallèlement à la surface du substrat, en dessous de la portion étroite.

Mais cette seconde méthode présente les inconvénients suivants. Tout d'abord, les caractéristiques de la jonction électrique qui est ainsi obtenue dépendent fortement de la largeur de la portion étroite. Or cette largeur n'est pas toujours contrôlée avec précision. L'isolation électrique du canal du transistor présente alors des fluctuations incontrôlées entre des transistors finFET qui sont réalisés avec des paramètres opératoires identiques. En outre, à cause d'une divergence résiduelle du faisceau d'implantation des particules dopantes de la portion active du substrat, et/ou à cause d'une inclinaison involontaire des côtés latéraux de la portion étroite, des particules dopantes destinées à la portion active du substrat sont aussi implantées dans la portion étroite. La mobilité et la concentration des porteurs électriques dans le canal présentent alors encore des variations involontaires.

En outre, dans les deux méthodes connues qui ont été rappelées ci-dessus, l'implantation involontaire de particules dopantes destinées à la portion active du substrat dans les côtés latéraux de la portion étroite provoque un facetage de ces côtés. Un tel facetage empêche d'obtenir une interface entre le canal et la couche d'isolation de grille du transistor finFET qui présente une faible rugosité.

Le document US 2005/156202 A1 décrit un procédé de réalisation d'un transistor à effet de champ de type finFET sur un substrat de circuit électronique intégré dans lequel une portion étroite de matériau semiconducteur cristallin comprenant au moins le canal du transistor est obtenu par croissance épitaxique au travers de l'ouverture d'un masque formé à la surface du substrat.

Un but de la présente invention consiste donc à réaliser un transistor finFET d'une façon qui ne présente pas les inconvénients cités ci-dessus.

En particulier, l'invention a pour but de proposer un procédé de réalisation d'un transistor finFET qui soit compatible avec l'utilisation d'un substrat massif («bulk») de circuit électronique intégré, tout en aboutissant à un transistor qui est isolé électriquement par rapport au substrat.

Pour cela, l'invention propose un procédé de réalisation d'un transistor à effet de champ de type finFET sur un substrat de circuit électronique intégré, qui comprend les étapes suivantes :
/1/ former un masque sur une surface du substrat, avec une ouverture du masque qui est située au dessus d'une partie exposée d'une portion active de ce substrat en matériau semiconducteur cristallin; et
/2/ former par croissance épitaxique à partir de la partie de portion active qui est exposée dans l'ouverture du masque, une portion étroite de matériau semiconducteur cristallin qui comprend au moins le canal du transistor.

Le procédé de l'invention comprend en outre l'étape suivante, qui est effectuée entre les étapes /1/ et /2/ précédentes:
- réaliser une implantation de particules dopantes par l'ouverture du masque dans la partie exposée de la portion active du substrat, de façon à créer dans celle-ci un dopage électrique d'un second type opposé à un premier type de dopage utilisé pour le canal du transistor.

Conformément à la structure de transistor finFET, le canal qui est constitué d'une partie de la portion étroite de matériau semiconducteur cristallin possède une direction de conduction électrique qui est parallèle à la surface du substrat. Il possède aussi une section perpendiculaire à cette direction de conduction qui est allongée perpendiculairement à la surface du substrat.

Ainsi, selon une première caractéristique de l'invention, la portion étroite qui forme le canal est constituée d'un matériau qui est déposé sur le substrat à l'étape /2/, et qui n'appartient donc pas initialement au substrat.

Selon une seconde caractéristique de l'invention, l'implantation de particules dopantes dans la portion active du substrat est effectuée avant que la portion étroite soit formée. De cette façon, la portion étroite, et par conséquent le canal du transistor finFET qui est réalisé, est complètement dépourvue de particules destinées à doper la portion active du substrat. Les caractéristiques électriques du canal ne sont donc pas perturbées par de telles particules de type opposé au dopage de la portion étroite. En particulier, la mobilité et la concentration des porteurs électriques du canal ne sont pas réduites involontairement. En outre, la rugosité des côtés latéraux de la portion étroite n'est pas augmentée par un facetage involontaire.

Dans le transistor finFET qui est obtenu, le canal et la portion active du substrat ont des dopages opposés et sont directement en contact l'un avec l'autre. Une jonction électrique est ainsi formée pour isoler électriquement le canal par rapport à la partie inférieure du substrat, ainsi que par rapport à d'autres canaux de transistors qui sont portés par le même substrat. Cette jonction électrique présente en outre des caractéristiques qui sont reproductibles. Notamment, ces caractéristiques sont indépendantes de la largeur de la portion étroite mesurée parallèlement à la surface du substrat.

Par ailleurs, le même masque est utilisé pour limiter transversalement l'implantation des particules dopantes dans la portion active du substrat et pour définir les dimensions de la portion étroite. Il est résulte que la jonction électrique d'isolation du canal est limitée à la zone du substrat qui est occupée par la portion étroite. De cette façon, la conductivité électrique du substrat reste très faible en dehors de la zone qui est occupée par la portion étroite, ce qui contribue à réduire encore plus d'éventuels courants de fuite qui circuleraient dans le substrat.

Un premier avantage d'un procédé selon l'invention résulte de la formation de la portion étroite par croissance épitaxique à partir du substrat. En effet, une telle méthode de formation de matériau sur un circuit électronique intégré est bien maîtrisée actuellement et permet d'obtenir des rendements de production élevés.

Un second avantage provient du type de l'isolation électrique qui est créée entre chaque transistor et le substrat. Cette isolation est similaire à celle de la technologie MOS (pour «Metal Oxide Semiconductor» en anglais) avec substrat massif («bulk»). Les acquis de cette technologie peuvent donc être repris en partie pour un circuit qui est réalisé conformément à l'invention.

Selon un perfectionnement de l'invention, la portion étroite peut comprendre, en plus du canal, des zones de source et de drain du transistor. Celles-ci sont alors isolées électriquement par rapport à la portion active du substrat de la même façon que le canal, de sorte qu'aucun courant de fuite ne peut circuler dans le substrat entre la source et le drain du transistor.

Le circuit électronique intégré obtenu selon le procédé de la présente invention, et qui incorpore un transistor à effet de champ de type finFET, comprend :
- un substrat ayant une portion active en matériau semiconducteur cristallin ; et
- une portion étroite en matériau semiconducteur cristallin, comprenant le canal du transistor et ayant un dopage électrique d'un premier type, et étant en contact avec la portion active du substrat au niveau d'une surface de ce substrat.

Dans un tel circuit, une partie de la portion active du substrat qui est en contact à la portion étroite est dopée selon un second type de dopage opposé au premier type. En outre, cette partie dopée de la portion active possède une limite de dopage qui est alignée par rapport à un côté de la portion étroite, perpendiculairement à la surface du substrat.

Un tel circuit à transistor finFET est réalisé en utilisant un procédé tel que décrit précédemment. Dans ce cas, l'alignement de la limite de dopage de la partie dopée de la partie de portion active du substrat résulte de l'utilisation du même masque pour doper sélectivement la partie de portion active et pour définir les dimensions transversales de la portion étroite parallèlement à la surface du substrat.

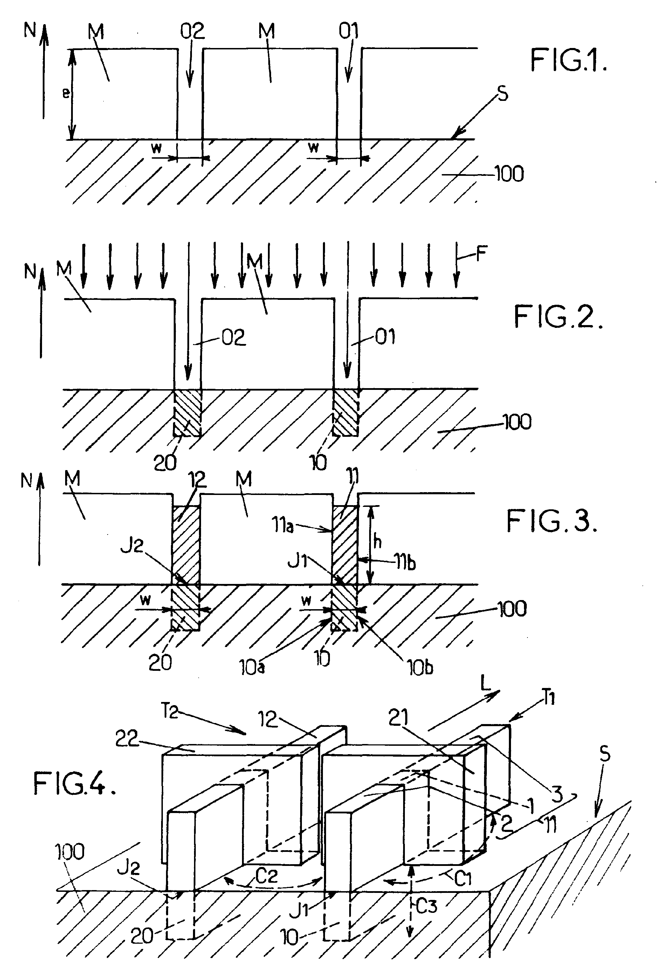

D'autres particularités et avantages de la présente invention apparaîtront dans la description ci-après d'un exemple de mise en oeuvre non limitatif, en référence aux figures 1-4 annexées. Ces figures illustrent des étapes successives d'un procédé de réalisation d'un circuit électronique intégré selon l'invention.

Pour raison de clarté, les dimensions des différents éléments qui sont représentés dans ces figures ne sont pas en proportion avec des dimensions ni avec des rapports de dimensions réels. Les figures 1-3 sont des vues en coupe d'un circuit électronique intégré en cours de réalisation à partir d'un substrat sensiblement plan, dans un plan de coupe qui est perpendiculaire à la surface du substrat. N désigne une direction perpendiculaire à la surface du substrat, orientée vers l'extérieur de celui-ci. Cette direction est reprise sur toutes les figures. Dans la suite, les termes «sur», «sous», «inférieur» et «supérieur» sont utilisés pour le circuit en référence avec cette orientation.

Dans ce qui suit, les étapes élémentaires du procédé de réalisation d'un circuit électronique intégré qui sont connues de l'Homme du métier ne sont pas décrites en détail. On s'attache seulement à décrire une succession d'étapes élémentaires qui permet de reproduire l'invention.

Conformément à la figure 1, un substrat massif («bulk substrate») de circuit électronique intégré est composé de silicium monocristallin, faiblement dopé ou non dopé. Il est référencé 100 et présente une surface supérieure S qui est plane. Une portion de ce substrat qui est adjacente à la surface S est utilisée pour former au moins un, par exemple deux transistors finFET à proximité l'un de l'autre. Cette portion est appelée portion active du substrat.

On forme sur la surface S du substrat 100 un masque M, qui présente des ouvertures aux emplacements des transistors à réaliser. Sur la figure 1, ces ouvertures sont notées O1 et 02. Elles possèdent des largeurs w qui peuvent être comprises entre 10 et 100 nm (nanomètre) environ. Le masque M peut être en silice (SiO₂) déposée chimiquement à partir de précurseurs gazeux, par exemple, et posséder une épaisseur e qui est comprise entre 10 et 100 nm selon la direction N, préférentiellement entre 60 et 100 nm. Les ouvertures O1 et O2 peuvent être formées en utilisant un masque de résine lithographique et un procédé de gravure directionnelle du masque M, par exemple.

On réalise alors une implantation de particules dopantes dans des parties de la portion active du substrat 100 qui sont découvertes dans les ouvertures O1 et O2. Pour cela, les particules dopantes sont accélérées sous forme d'un faisceau F qui est dirigé contre la surface supérieure du circuit, parallèlement à la direction N et en sens opposé à celle-ci (figure 2). La surface du circuit est balayée avec le faisceau F. Les particules dopantes sont ainsi implantées dans le substrat 100, sélectivement à l'intérieur de parties de la portion active qui sont référencées 10 et 20 et qui sont limitées par les bords des ouvertures O1 et O2 parallèlement à la surface S du substrat 100. La profondeur des parties 10 et 20, selon la direction N, et la concentration des particules dopantes dans ces parties sont fixées par l'énergie et l'intensité du faisceau F.

Après l'implantation des parties 10 et 20, le masque M est conservé sur le circuit. Un dépôt de matériau semiconducteur cristallin est ensuite effectué, dans des conditions qui sont adaptées pour obtenir une croissance épitaxique du matériau qui est formé à partir de matériau semiconducteur cristallin déjà présent dans le circuit et qui est découvert. De cette façon, des portions monocristallines 11 et 12 sont formées (figure 3), qui sont par exemple en silicium ou en alliage de silicium et de germanium, ou encore en silicium incorporant du carbone. La composition des portions 11 et 12 peut être sélectionnée notamment pour obtenir un matériau constitutif de celles-ci qui soit précontraint. De préférence, la formation des portions 11 et 12 est arrêtée avant qu'elles dépassent au dessus du masque M. De cette façon, les portions 11 et 12 présentent des côtés latéraux parallèles à la direction N qui sont plans jusqu'aux sommets de ces portions.

Du fait de l'utilisation du masque M pour effectuer l'implantation sélective des parties 10 et 20 du substrat 100 puis pour former les portions 11 et 12, chaque partie dopée 10, 20 du substrat possède deux limites opposées qui sont alignées respectivement avec deux côtés opposés de la portion 11, 12 correspondante, selon la direction N. Sur la figure 3, les limites latérales de la partie dopée 10 de la zone active du substrat 100 sont référencées 10a et 10b, et les côtés de la portion 11 sont référencées 11a et 11b. Il en résulte que les portions 11 et 12 ont chacune la largeur w, qui est commune avec les parties dopées 10 et 20 du substrat. Etant donné que les portions 11 et 12 possèdent une hauteur h selon la direction N qui est préférablement plus grande que la largeur w, les portions 11 et 12 sont appelées portions étroites («fins» en anglais).

Les portions 11 et 12 peuvent être dopées soit directement pendant leur formation épitaxique, soit après leur formation lors d'une étape distincte. Le dopage des portions 11 et 12 est sélectionné pour être de type opposé à celui des parties 10 et 20 de la portion active du substrat 100. Par exemple, les parties 10 et 20 ont un dopage de type p, qui peut être obtenu avec du bore (B), et les portions 11 et 12 ont un dopage de type n, qui peut être obtenu avec du phosphore (P) ou de l'arsenic (As). Des jonctions électriques, qui sont notées J1 et J2 sur la figure 3, sont ainsi obtenues au niveau des interfaces de contact des portions 11 et 12 respectivement avec les parties 10 et 20.

La réalisation des transistors finFET peut alors être poursuivie d'une façon qui est connue en soi, à partir des portions étroites 11 et 12 (figure 4). Le masque M est retiré, par exemple en utilisant un procédé de gravure sélective de la silice. Les portions 11 et 12 peuvent alors être oxydées thermiquement en surface, afin de créer sur celles-ci de fines couches d'isolation de grille (non représentées). Des portions de grilles 21 et 22, qui peuvent être en polysilicium (poly-Si), sont ensuite formées par dessus chaque portion 11 et 12. Les portions de grilles 21 et 22 peuvent avoir la forme de ponts qui chevauchent respectivement par le dessus les portions étroites 11 et 12, en étant isolées électriquement de ces dernières. Des parties médianes des portions 11 et 12, qui sont respectivement au contact des portions de grilles 21 et 22 par les surfaces internes de celles-ci, constituent les canaux des transistors finFET correspondants.

De préférence, chaque portion étroite 11, 12 peut posséder des extrémités qui dépassent de chaque côté de la portion de grille 21, 22 correspondante. Dans ce cas, chaque portion étroite comprend, en plus du canal, des zones de source et de drain du transistor finFET obtenu. Sur la figure 4 qui est une vue en perspective du circuit obtenu, la portion étroite 11 constitue le canal 1 et les zones de source 2 et de drain 3 d'un même transistor. Les zones de source 2 et de drain 3 sont ainsi situées dans le prolongement continu du canal 1 de chaque côté de celui-ci. L désigne la direction de conduction de ce transistor, qui est parallèle à la surface S. La jonction électrique J1 s'étend aussi continûment sous le canal 1 et sous les zones de source 2 et de drain 3.

Les deux transistors qui sont obtenus sont notés T1 et T2. La portion 11 qui forme le canal et les zones de source et de drain du transistor T1 est isolée du substrat 100 par la jonction électrique J1, lorsque la portion 11 est portée à un potentiel électrique qui est supérieur à celui du substrat 100. De même, la portion 12 qui forme le canal et les zones de source et de drain du transistor T2 est isolée du substrat 100 par la jonction électrique J2. De cette façon, les chemins de courants de fuite suivants sont coupés par les jonctions électriques J1 et J2 : le chemin C1 qui relie, pour chaque transistor T1, T2 à travers le substrat 100, les zones de source et de drain du même transistor, le chemin C2 qui relie les portions étroites 11 et 12 entre elles à travers le substrat 100, et le chemin C3 qui relie chaque portion étroite 11, 12 à une partie inférieure du substrat 100. Chaque transistor T1, T2 est donc isolé électriquement de façon efficace, de sorte qu'aucun courant de fuite via le substrat 100 ne perturbe son fonctionnement.

Il est entendu que de nombreuses adaptations de l'invention peuvent être introduites par rapport à la mise en oeuvre qui a été décrite en détail ci-dessus, tout en conservant certains au moins des avantages de celle-ci. En particulier, les dimensions et les matériaux qui ont été cités peuvent être modifiés. De plus, l'invention peut être combinée avec des méthodes déjà connues pour réduire l'épaisseur w des portions étroites de transistors finFET.

Enfin, un mode alternatif de mise en oeuvre de l'invention peut consister à former le matériau de la portion étroite avec une composition initiale qui comprend déjà son dopage électrique. La jonction électrique d'isolation de la portion étroite est alors directement obtenue au moment de la formation épitaxique de cette portion étroite. En effet, des procédés de croissance épitaxique de matériaux semiconducteurs dopés sont connus de l'Homme du métier, qui aboutissent directement à des niveaux de dopage appropriés pour former une jonction d'isolation électrique. Une fois que la jonction est réalisée, le procédé de croissance épitaxique de la portion étroite peut être poursuivi dans des conditions qui aboutissent à un dopage intrinsèque plus faible.

## Revendications

1. Procédé de réalisation d'un transistor (T1) à effet de champ de type finFET sur un substrat (100) de circuit électronique intégré,
le transistor comprenant un canal (1) constitué d'un matériau semiconducteur dopé électriquement selon un premier type de dopage,
le canal ayant une direction de conduction électrique (L) parallèle à une surface (S) du substrat et une section perpendiculaire à ladite direction de conduction, ladite section étant allongée perpendiculairement à la surface du substrat,
le substrat (100) ayant une portion active en matériau semiconducteur cristallin exposée initialement à la surface (S) dudit substrat,
le procédé comprenant les étapes suivantes :
/1/ former un masque (M) sur la surface du substrat, ledit masque comportant une ouverture (01) située au dessus d'une partie (10) de la portion active du substrat ; et
/2/ former, par croissance épitaxique à partir de la partie de portion active (10) qui est exposée dans l'ouverture du masque, une portion étroite (11) de matériau semiconducteur cristallin comprenant au moins le canal (1) du transistor,
et comprenant en outre l'étape suivante, effectuée entre les étapes /1/ et /2/ :
- réaliser une implantation de particules dopantes (F) par l'ouverture du masque (O1) dans ladite partie exposée de la portion active du substrat (10), de façon à créer dans ladite partie exposée de portion active, un dopage électrique d'un second type opposé au premier type.

2. Procédé selon la revendication 1, suivant lequel la portion étroite (11) comprend, en plus du canal (1), des zones de source (2) et de drain (3) du transistor.

3. Procédé selon la revendication 1 ou 2, suivant lequel la portion étroite (11) est directement dopée pendant sa formation à l'étape /2/.

4. Procédé selon la revendication 1 ou 2, suivant lequel la portion étroite (11) est dopée après l'étape /2/.

## Claims

1. Process for realizing a finFET field effect transistor (T1) on a substrate (100) of an integrated electronic circuit,
the transistor comprising a channel (1) comprised of a semiconducting material doped electrically according to a first doping type,
the channel having an electrical conduction direction (L) parallel with a surface (S) of the substrate and a cross-section perpendicular to said conduction direction, said cross-section being elongated perpendicular to the substrate surface,
the substrate (100) having an active portion of crystalline semiconducting material which is exposed initially at the substrate surface (S),
the process comprising the following steps:
/1/ forming a mask (M) on the surface of the substrate, with said mask comprising an opening (O1) located above a part (10) of the active portion of the substrate; and
/2/ forming, by epitaxial growth from the part of the active portion (10) which is exposed in the mask opening, a thin fin portion (11) of crystalline semiconducting material comprising at least the channel (1) of the transistor,
and further comprising the following step, performed between steps /1/ and /2/:
- realizing an implantation of doping particles (F) through the mask opening (O1) into said exposed part of the active portion of the substrate (10), so as to create in said exposed part of the active portion, an electrical doping of a second type opposed to the first type.

2. Process according to claim 1, wherein the thin fin portion (11) comprises source (2) and drain (3) zones of the transistor in addition to the channel (1).

3. Process according to claim 1 or 2, wherein the thin fin portion (11) is doped directly during its formation in step /2/.

4. Process according to claim 1 or 2, wherein the thin fin portion (11) is doped subsequent to completion of step /2/.

## Patentansprüche

1. Verfahren zur Herstellung eines Feldeffekttransistors (T1) vom finFET-Typ auf einem Substrat (100) eines integrierten elektronischen Schaltkreises,
wobei der Transistor einen Kanal (1) umfasst, der aus einem gemäß einem ersten Dotierungstyp elektrisch dotierten Halbleitermaterial besteht,
wobei der Kanal eine Richtung der elektrischen Leitung (L) parallel zu einer Oberfläche (S) des Substrats und einen Abschnitt senkrecht zu der Leitungsrichtung aufweist, wobei sich der Abschnitt senkrecht zu der Substratoberfläche erstreckt,
wobei das Substrat (100) einen aktiven Teil aus kristallinem Halbleitermaterial aufweist, welcher anfänglich auf der Oberfläche (S) des Substrats exponiert ist,
wobei das Verfahren folgende Schritte umfasst:
/1/ Ausbilden einer Maske (M) auf der Oberfläche des Substrats, wobei die Maske eine Öffnung (01) aufweist, die oberhalb eines Teilstücks (10) des aktiven Teils des Substrats angeordnet ist; und
/2/ Ausbilden eines schmalen Teils (11) aus kristallinem Halbleitermaterial, welcher wenigstens den Transistorkanal (1) umfasst, durch epitaktisches Wachstum ausgehend von dem Teilstück des aktiven Teils (10), der in der Öffnung der Maske exponiert ist,
und wobei das Verfahren außerdem folgenden Schritt umfasst, der zwischen den Schritten /1/ und /2/ durchgeführt wird:
- Durchführen einer Implantation von Dotand-Partikein (F) durch die Maskenöffnung (01) in dem exponierten Teilstück des aktiven Teils des Substrats (10) derart, dass in dem exponierten Teilstück des aktiven Teils eine elektrische Dotierung eines zweiten Typs, die dem ersten Typ entgegengesetzt ist, erzeugt wird.

2. Verfahren gemäß Anspruch 1, wobei der schmale Teil (11) neben dem Kanal (1) Source- (2) und Drain-Zonen (3) des Transistors umfasst.

3. Verfahren gemäß Anspruch 1 oder 2, wobei der schmale Teil (11) direkt während seiner Bildung in Schritt /2/ dotiert wird.

4. Verfahren gemäß Anspruch 1 oder 2, wobei der schmale Teil (11) nach dem Schritt /2/ dotiert wird.
